Europäisches Patentamt

European Patent Office

Office européen des brevets

(19)

(11) Veröffentlichungsnummer: **0 044 800**
**B1**

(12) **EUROPÄISCHE PATENTSCHRIFT**

(45) Veröffentlichungstag der Patentschrift:
**29.01.86**

(51) Int. Cl.⁴: **G 10 K 13/00**, B 06 B 3/00

(21) Anmeldenummer: **81710022.5**

(22) Anmeldetag: **11.07.81**

(54) **Vorrichtung und Verfahren zur Erzeugung und Abstrahlung von Ultraschallenergie.**

(30) Priorität: **21.07.80 DE 3027533**

(43) Veröffentlichungstag der Anmeldung:
**27.01.82 Patentblatt 82/4**

(45) Bekanntmachung des Hinweises auf die Patenterteilung:
**29.01.86 Patentblatt 86/5**

(84) Benannte Vertragsstaaten:
**AT BE CH DE FR GB IT LI NL SE**

(56) Entgegenhaltungen:
**DE - C - 879 179**
**FR - A - 1 194 086**
**FR - A - 1 359 616**
**US - A - 4 016 436**

(73) Patentinhaber: **TELSONIC AG für elektronische Entwicklung und Fabrikation, Industriestrasse, CH-9552 Bronschhofen (CH)**

(72) Erfinder: **Frei, Karl, Industriestrasse, CH-9552 Bronschhofen (CH)**

(74) Vertreter: **Hiebsch, Gerhard F., Dipl.-Ing., Erzbergerstrasse 5A Postfach 464, D-7700 Singen 1 (DE)**

ACTORUM AG

### Beschreibung

Die Erfindung betrifft eine Vorrichtung sowie ein Verfahren zur Erzeugung und Abstrahlung von Ultraschallenergie in Flüssigkeiten mit einem Schallwandler und einem daran angeschlossenen hohl ausgebildeten Resonator, dessen Wand mit der Flüssigkeit in Berührung steht.

Ultraschall-Reinigungsanlagen umfassen üblicherweise mindestens drei Anlageteile, nämlich einen die Reinigungsflüssigkeit oder das Kopplungsmedium enthaltenden Tank, einen elektrischen Ultraschallgenerator sowie einen elektroakustischen Schallwandler. Letzterer setzt die vom Generator erzeugten elektrischen Schwingungen gleicher Frequenz um. Solche Schallwandler sind einzeln oder in Gruppen an Tankböden oder Wänden befestigt. Bei grösseren Anlagen werden die Schallwandler auch in wasserdichte Gehäuse gebaut, die dann ihrerseits in die Badflüssigkeit versenkt werden.

Man unterscheidet heute vor allem zwischen zwei Schallwandlertypen, nämlich zum einen den

magnetostriktiven Schallwandlern und zum anderen den piezoelektrischen Schallwandlern.

Der magnetostriktive Nickel-Eisen-Schallwandler ist der historisch ältere Typ. Im Interesse eines guten Umwandlungswirkungsgrades werden alle Leistungsschallwandler auf oder in der Nähe ihrer mechanischen Eigenresonanz betrieben. Durch diese Forderung sind aber bereits die wichtigsten Parameter eines Schallwandlers und seine Abmessungen festgelegt, wenn seine Frequenz bekannt ist.

Der Hauptnachteil, der allen Schallwandlern anhaftet, ist die sehr schlechte akustische Anpassung an die Last, d.h. an die Badflüssigkeit. Um die Anpassung zu verbessern, muss die strahlende Fläche so gross wie möglich sein. Dieser Forderung sind aber eindeutig Grenzen gesetzt, indem die maximalen lateralen Abmessungen des Schallwandlers durch die Arbeitsfrequenz einerseits und die Fortpflanzungsgeschwindigkeit im Material andererseits begrenzt sind. Ein typischer piezoelektrischer Schallwandler für eine Arbeitsfrequenz von 20 kHz hat eine Länge von ca. 100 mm und eine laterale Abmessung von ca. 65 mm. Der Schallkennwiderstand $Z_o$, der die Anpassung in erster Linie bestimmt, liegt für Flüssigkeiten zwischen 1 und 1,5 kg/m²s ($Z_o$ Wasser = 1,485 kg/m²s), derjenige von Aluminium und Stahl – den meist verwendeten Materialien – liegt bei 17 bzw. 46 kg/m²s. Es ist demnach mit einer Fehlanpassung von ca. 1:17 bis 1:46 zu rechnen. Demzufolge hat der ganze Schallwandler unter Last eine mechanische Schwinggüte von ca. 17 im Falle von Aluminium und ca. 46 im Falle von Stahl. Diese relativ hohen Schwinggüten unter Last aber bedeuten, dass nur ca. 2 bis 6% der am Schallwandler erhältlichen Energie auch wirklich abgestrahlt werden. Der Rest von 94 bis 98% zirkuliert als Blindleistung im Wandler und verursacht dort nur eine unerwünschte Erwärmung und einen schlechten Leistungsfaktor.

Da der Wandler mechanisch (Bruchfestigkeit) durch den Strom und elektrisch durch die Spannung (Durchschlagfestigkeit) begrenzt ist, muss er also im Interesse einer guten Ausnützung seines Potentials und der investierten Kosten möglichst gut an die Last (Reinigungsflüssigkeit) angepasst werden. Einer guten Anpassung aber setzt sich noch ein anderer Faktor entgegen. Die pro Flächeneinheit abgestrahlte Leistung lässt sich nicht beliebig vergrössern, da durch die Kavitation eine teilweise Entkoppelung stattfindet, die gleichbedeutend mit einer Abnahme von $Z_o$ der Flüssigkeit ist. Der heutige Stand der Technik besteht nun darin, dass man eine Vielzahl von Schallwandlern an Wannenböden oder am Tauchschwingergehäuse montiert und auf diese Weise bei sehr hohen Investitionen zu einer grösseren Strahlungsfläche kommt. Die Aufteilung der Schallquelle in getrennte Einzelschwinger, die von einem Generator gespeist werden, führt allerdings zu einer besseren Schallhomogenität. Es wäre sehr unerwünscht, wenn die gesamte Ultraschall-Leistung in einem Bad von ca. 2 l an aufwärts von einem einzigen Schallwandler abgestrahlt werden müsste, da daraus eine sehr starke Inhomogenität der US-Intensität resultieren würde. Es wird deutlich, dass hier Probleme nicht nur wegen der schlechten akustischen Anpassung des einzelnen Schallwandlers an das Medium bestehen sondern auch in Bezug auf Schallhomogenität, Kavitationsfrass, Lebensdauer, Zuverlässigkeit, Kosten od. dgl. mehr.

Eine Vorrichtung zum Abstrahlen von Ultraschallenergie der eingangs erwähnten Art offenbart die US-A-4 016 436; deren Schallwandler ist mit einem Dehnungsresonator verbunden und dieser teilweise in einen Rohrresonator eingeschoben. Jener Dehnungsresonator führt longitudinale Schwingungen aus, wobei im Bereich eines von ihm am Ort eines radialen Schwingungsmaximums abkragenden Kupplungsbundes Änderungen von dessen Querschnitt auftreten. Da nun der Rohrresonator dem Kupplungsbund anliegt, wirken sich jene periodischen Querschnittsänderungen des Dehnungsresonators auch auf den Rohrresonator durch entsprechende Änderungen von dessen Querschnitt aus. Letztere wiederum pflanzen sich dann am Rohrresonator fort und vermindern sich mit zunehmendem Abstand zum Dehnungsresonator in nachteiliger Weise.

Dies bedeutet, dass der Rohrresonator bezüglich seiner Wirkung stark längenabhängig ist; selbst bei der Verarbeitung von nur kleinen Leistungen wird die Änderung des Querschnitts des Dehnungsresonators, die verhältnismässig intensiv vor sich gehen kann, zu einer der Endpartien des Rohrresonators über den bereits erwähnten Übergangsbereich übertragen. Hierbei erfolgt eine erste Abschwächung der Querschnittsänderung und somit auch eine Minderung der übertragenen Schallenergie. Diese Schwingung mit bereits verminderter Amplitude pflanzt sich dann entlang des Rohrresonators fort, wobei dann – wie bekannt – bei der Fortpflanzung von Wellen in festen Stoffen eine mehr oder weniger starke Dämpfung der Wellen erfolgt.

Als weiterer Mangel ist anzusehen, dass ein wünschenswert möglich vollkommenes Berühren des Rohrresonators auf dem Kupplungsbund des Dehnungsresonators technologisch kaum zu erreichen ist; ein sattes Aufliegen aber bleibt Voraussetzung für das Funktionieren der Vorrichtung nach US-A-4 016 436. Der Übergangsbereich zwischen Dehnungsresonator und Resonator während des Betriebes wird hier durch sehr grosse Kräfte beansprucht, deren Richtung zudem rasch wechselt. Würde man also die vorbekannte Apparatur zur Verarbeitung grosser Leistungen einsetzen, müsste jene Apparatur sehr bald ausfallen!

Angesichts dieser Gegebenheiten hat sich der Erfinder das Ziel gesetzt, bei einer Vorrichtung sowie mit einem Verfahren der eingangs genannten Art eine möglichst gleiche periodische Abstrahlung von Energiemengen über die gesamte Länge des hohlen Resonators zu erreichen. Es soll also bei der Übertragung von Ultraschallschwingungen in der Badflüssigkeit eine wesentliche Verbesserung des Wirkungsgrades erzielt werden mit einer Vorrichtung, die gegenüber dem beschriebenen Stand der Technik einfacher herzustellen sowie betriebssicherer zu betreiben ist.

Zur Lösung dieser Aufgabe führt, dass das Ende des Resonators am Ort eines longitudinalen Schwingungsmaximums an eine Stirnfläche des Schallwandlers angeschlossen ist, und dass die Gesamtlänge des Resonators auf ein ganzzahliges Vielfaches einer halben Wellenlänge der vom Schallwandler in den Resonator eingespeisten Longitudinalschwingung – also der akustischen Länge $\lambda/_2$ der Arbeitsfrequenz zur Erzeugung von Querkontraktionen an den Dehnungsknoten der Arbeitsfrequenz – abgestimmt ist.

Die erfindungsgemässe Vorrichtung ist dank ihrer Ausbildung von allen genannten Nachteilen frei. Sie enthält einen – eine longitudinale Schwingung erzeugenden Schallwandler, an dessen Schallaustrittsfläche der Resonator direkt anschliesst. Hierzu kann beispielsweise die Stirnfläche der Endpartie des Resonators der Schallaustrittsfläche des Schallwandlers stumpf aufliegen. Dieses Eintrittsende des Resonators schwingt somit ebenfalls longitudinal – und nicht transversal.

Die also in den Resonator erfindungsgemäss direkt eingespeiste intensive longitudinale Schwingung verursacht periodische Änderung des Querschnitts in bestimmten Bereichen des Resonators. Diese Bereiche liegen in den Dehnungsbäuchen der Longitudinalschwingungen, und in jedem dieser Bereiche erfolgt eine intensive Transformation der longitudinalen in transversale Schwingung. Da die Amplitude jedes longitudinalen Stehwellenmaximums gleich ist, ist auch die Amplitude jedes radialen Amplitudenmaximums gleich. Die Abstrahlintensität ist hier also unabhängig von der Resonatorlänge, vorausgesetzt, die Länge ist ein ganzzahliges Vielfaches von $\lambda/2$.

Im Gegensatz dazu ergibt sich nach der US-A-4 016 436 jede nachfolgende Querschnittsänderung wegen der Fortpflanzung der Welle erst aus der jeweils vorangehenden Querschnittsänderung. Die nachfolgenden Querschnittsänderungen werden somit immer schwächer und schwächer, was den Wirkungsgrad eines solchen Apparates erkennbar in äusserst nachteiliger Weise beeinflusst.

Nach einem weiteren Merkmal der Vorrichtung ist der Resonator als Rundstab ausgebildet. Sein Querschnitt kann auch polygon – etwa quadratisch oder rechteckig – sein. Von besonderem Vorteil ist ein solcher Resonator, dessen Hohlprofil mit der Flüssigkeit gespeist wird. Hierbei erfolgt die Abstrahlung nach innen, was durch die Fokusierung zu sehr hohen Schallintensitäten führt.

Im Rahmen der Erfindung liegt, dass der Resonator unter Zwischenschaltung eines Transformationsstückes mit einem – beispielsweise piezoelektrischen – Wandler verbunden ist. Dank dieses Transformationsstückes ist die Amplitude wunschgemäss leicht zu verändern bzw. anzupassen. Insgesamt gestattet die erfindungsgemässe Konzeption eine leichte Transformation der Amplitude, ohne dass die Strahlfläche verringert werden müsste.

Bei einer vorteilhaften Ausführungsform ist der piezoelektrische Wandler durch einen Magnetostriktionswandler ersetzt.

Ausserdem hat es sich als günstig erwiesen, das Ende des Resonators durch einen akustischen Transformator zu verschliessen.

Mit einer derartigen Vorrichtung können hohe Ultraschalleistungen in Flüssigkeiten abgestrahlt werden, was die erwünschten technischen und wirtschaftlichen Vorzüge mit sich bringt, nämlich – gegenüber gleichwertigen Tauchschwingern – niedrige Herstellungskosten und leichte Lagerhaltung, da nur der Resonator kundenspezifisch gefertigt werden muss, während es einen einzigen Typ von Schallwandler gibt. Darüber hinaus ist ein sehr leichtes und schnelles Anpassen an Spezialgrössen ohne Aufwand möglich.

Ebenfalls wird der Transport erleichtert, da die erfindungsgemässe Vorrichtung nur ein geringes Gewicht aufweist. Auch hat es sich gezeigt, dass die Lebensdauer des Resonators die eines Tauchschwingers oder einer Schallwanne um ein Mehrfaches übertrifft und darüber hinaus der Resonator sowohl der Schallwanne als auch dem Tauchschwinger technisch und wirtschaftlich überlegen ist.

Ein besonderer Vorteil muss darin gesehen werden, dass nur noch etwa 5% der heute für (PZT-) Bleizirkonattitanat-Scheiben notwendigen Kosten anfallen und die problematische Klebung der Wandler entfällt.

Die technischen Vorteile sind von allem, dass ein einziger Wandler für Leistungen bis etwa 1000 Watt benötigt wird, da die Anpassung erleichtert ist. Auch die Anpassung an den Generator wird unproblematisch, da Lastaufteilungsprobleme entfallen, die bei der parallelen Schaltung vieler Wandler auftreten. Ebenfalls ist eine geringere Pegelabhängigkeit wegen der Rundstrahlcharakteristik zu verzeichnen, ausserdem eine geringere spezifische Flächenbelastung und dadurch ein verminderter Kavitationsfrass.

Mit der erfindungsgemässen Vorrichtung können vorteilhafterweise Anlagen mit höherer Betriebsfrequenz als 20 kHz (beispielsweise 40 kHz) leicht realisiert werden. Es entfallen zudem Klebungen oder Schweissungen von Schallwandlern an Wannen oder Gehäusewänden, es entstehen keine Dichtungsprobleme, da keine kritischen Teile im Bad hängen (vergleiche Tauchschwinger), die durch das Eindringen von Flüssigkeiten zerstört werden könnten.

Die erfindungsgemässe Vorrichtung ist in allen Lagen einbaubar und der Platzbedarf für den Resonator geringer als derjenige eines Tauchschwingers, ebenfalls beträgt das Gewicht des Resonators nur einen Bruchteil des Gewichtes konventioneller Tauchschwinger.

Bei der Verwendung schon eines einzelnen rohrartigen Resonators entsteht eine hochintensive Reinigungswirkung im Zentrum des Rohres, auch ist eine Durchflussbeschallung möglich (Drahtreinigung). Zudem können nach einem weiteren Merkmal der Erfindung zwecks Intensivierung der Beschallung im Durchflussbetrieb zumindest zwei Resonatoren übereinander geschoben werden.

Bei Durchführung des erfindungsgemässen Verfahrens wird die vorstehend erläuterte erfindungsgemässe Vorrichtung eingesetzt werden. Letztere kann vorteilhafterweise noch dadurch ergänzt werden, dass dem Resonator zumindest ein Reflektor zugeordnet ist zur Durchführung des erfindungsgemässen Verfahrensschrittes, die Rundstrahl-Charakteristik zu verändern und die Abstrahlung in eine einstellbare Richtung zu verstärken.

Der erfindungsgemässe Resonator ist bei geeigneter Dimensionierung einer sehr geringen Materialabtragung durch die kleinere spezifische Kavitationsbeanspruchung unterworfen, weshalb seine Lebenserwartung unverhältnismässig hoch ist bei annähernd gleichbleibender Abstrahleffizienz – dies im Vergleich mit einer Batterie von Einzelwandlern.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:

Fig. 1: einen schematisierten Längsschnitt durch eine erfindungsgemässe Vorrichtung;

Fig. 2: ein Schaubild zum Amplitudenverlauf;

Fig. 3: eine äquivalente Ersatzschaltung für einen magnetostriktiven Wandler;

Fig. 4: eine äquivalente Ersatzschaltung für einen piezoelektrischen Wandler.

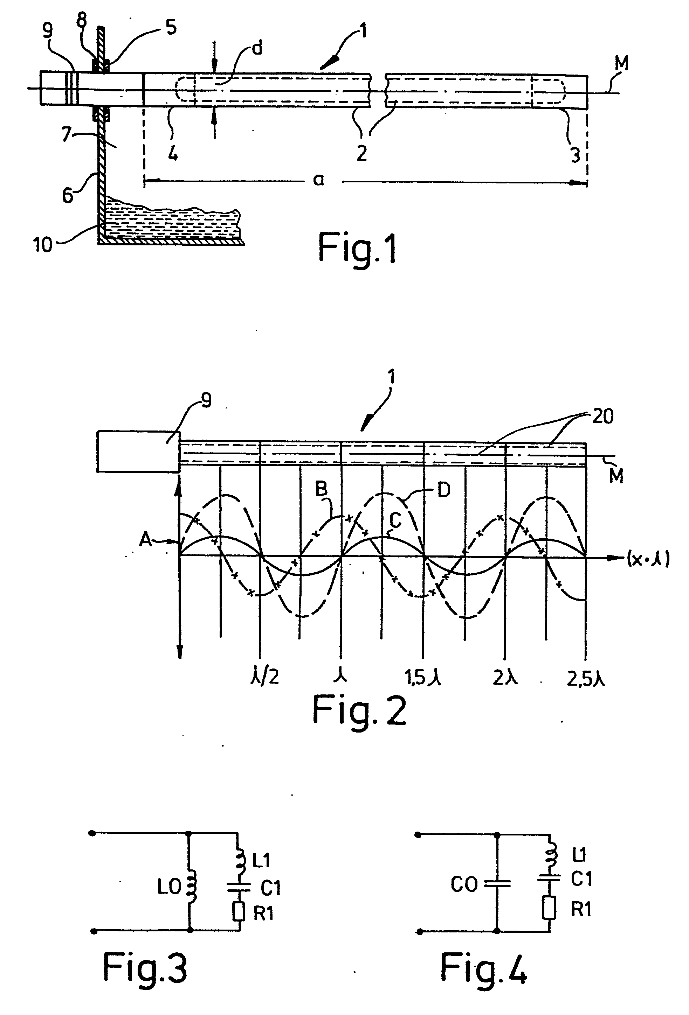

Ein Ultraschallresonator 1 weist nach Fig. 1 einen stab- oder rohrförmigen Körper 2 auf, dessen Querschnitt rund oder mehrkantig ausgebildet sein kann. Dieser Resonator 1 ist in seiner Abmessung in Längsachse M auf ein ganzzahliges Vielfaches einer halben Wellenlänge ($\lambda/2$) abgestimmt.

Der Körper 2 des Resonators 1 endet auf der rechten Figurenseite in einem akustischen Transformator 3, welcher den hohlen Körper 2 verschliesst und dort die Longitudinalamplitude verkleinert. Er ist andernends mittels eines ($\lambda/2$-) Transformationsstückes 4 mit einem piezoelektrischen Konverter 9 verbunden, welcher in seinem Amplitudennullpunkt einen Montageflansch 5 trägt, der im gewählten Ausführungsbeispiel an der Wand 6 – oder dem Boden – eines bei 7 angedeuteten Reinigungstankes sitzt.

Der piezoelektrische Konverter 9 durchbricht die Wand 6 bzw. den Boden des Reinigungstanks 7 und wird mittels eines Press- und Dichtungsflansches 8 fest mit der Wand 6 verbunden.

Der aus einem Metall oder einer Metallegierung gefertigte Resonator 1 wird vom einzigen Schallwandler 9, dessen eigene Resonanzfrequenz mit der eigenen Resonanzfrequenz des Resonators 1 übereinstimmt, im Longitudinalwellenmod angeregt. Ausserdem steht der Resonator 1 in vollem Umfang mit der Badflüssigkeit 10 im Reinigungstank 7 in direktem Kontakt. Der Resonator 1 ist so dimensioniert, dass die Longitudinalwellen in ihrem Dehnungsbauch Dehnungswellen gleicher Frequenz erzeugen, welche ihrerseits in die Badflüssigkeit 10 abgestrahlt werden.

Da Scherkräfte in Flüssigkeiten nicht übertragen werden, wird nicht die Longitudinalwelle abgestrahlt sondern die durch sie erzeugte Radialkomponente oder die erwähnte Dehnungswelle. Die Amplitude dieser Radialkomponente ist gegenüber der Amplitude der Longitudinalwelle um 90° phasenverschoben und wird in ihrer Höhe durch die Poisson'sche Querzahl, die Longitudinalamplitude und die Geometrie des Resonators 1 bestimmt.

Je nach der gewählten Länge a und Resonanzfrequenz des Resonators 1 werden bis zu zehn oder mehr Halbperioden einer stehenden Welle aufgebaut.

Fig. 2 verdeutlicht den Amplitudenverlauf am Resonator 1, der in einem Gedankenmodell in einzelne Wandlerabschnitte 20 aufgeteilt ist. Die Amplitude ist auf der Vertikalachse A der Fig. 2 aufgetragen. Kurve B gibt den Amplitudenverlauf der Longitudinalschwingung, Kurve C den Amplitudenverlauf der Radialschwingungskomponente sowie Kurve D den Amplitudenverlauf der Dehnung der Longitudinalschwingung wieder.

Um jeden Dehnungsknoten ergibt sich ein konzentrisches Band einer radial abstrahlenden Fläche. Diese aktive Fläche kann um ein Mehrfaches grösser sein als diejenige eines einzelnen Schallwandlers.

Multipliziert man diese konzentrischen Strahlungsflächen mit der Zahl der Halbwellen der Longitudinalschwingung, so erzielt man leicht eine aktive Strahlungsfläche, die grösser ist als eine ganze Batterie montierter Einzelschallwandler. Damit aber wird gleichzeitig eine sehr gute Anpassung an die Badflüssigkeit eines einzigen Schallwandlers gewährleistet.

In der Praxis wird man vorteilhafterweise einen Rohrkörper 2 von einigen Millimetern Wandstärke verwenden. Durch Wahl von dessen Durchmesser d ist es möglich, die Radialkomponente der Schwingung zu optimieren, indem die natürliche Radialresonanzfrequenz mit der Longitudinalresonanzfrequenz zusammenfällt. Dies aber ist keine Bedingung für die Funktionsweise.

Da vom Strahler sehr hohe Kavitationsfestigkeit und gute Chemikalienbeständigkeit verlangt wird, besteht der Rohrkörper 2 bevorzugt aus einer Legierung von Cr Ni Fe bzw. Titan. Die Titanlegierungen sind teuer und oft schwer zu beschaffen; übrig bleiben die Stahllegierungen, allerdings mit relativ hohen inneren Verlusten. Um diese auszugleichen wird nicht ein massiver Stab genommen sondern der relativ dünnwandige Rohrkörper 2. Die Verluste sind proportional dem Materialvolumen und dazu stark amplituden- und frequenzabhängig.

Der ganze Resonator 1 kann mit einem Schallwandler 9 in einem Ersatzschaltbild zusammengefasst werden, das den folgend beschriebenen Darstellungen in Fig. 3 bzw. 4 etwa entspricht sowie für Frequenzen in der Nähe der Eigenresonanzfrequenz Gültigkeit hat.

Fig. 3 zeigt das Ersatzschaltbild für einen magnetostriktiven Schallwandler 9 mit Resonator 1, wohingegen Fig. 4 das Ersatzschaltbild für einen piezoelektrischen Schallwandler 9 mit Resonator 1 wiedergibt. Darin ist:

$L1$ = Induktivität des äquivalenten mechanischen Resonanzkreises
$C1$ = Kapazität des äquivalenten mechanischen Resonanzkreises
$R1$ = Summe des Last- und Verlustwiderstandes (auch Strahlungswiderstand genannt)
$Lo$ = Statische Wandlerparallelinduktivität
$Co$ = Statische Wandlerparallelkapazität

Die Analyse der beiden Schaltbilder zeigt, dass mit zunehmendem Lastwiderstand die Blindleistung sinkt und die Wirkleistung steigt, was gleichbedeutend mit einer besseren Anpassung des Schallwandlers an die Last ist.

**Patentansprüche**

1. Vorrichtung zur Erzeugung und Abstrahlung von Ultraschallenergie in Flüssigkeiten mit einem Schallwandler (9) und einem daran angeschlossenen, hohl ausgebildeten Resonator (1), dessen Wand mit der Flüssigkeit in Berührung steht, dadurch gekennzeichnet, dass das Ende des Resonators (1) am Ort eines longitudinalen Schwingungsmaximums an eine Stirnfläche des Schallwandlers (9) angeschlossen ist, und dass die Gesamtlänge des Resonators (1) auf ein ganzzahliges Vielfaches einer halben Wellenlänge ($\lambda/2$) der vom Schallwandler (9) in den Resonator (1) eingespeisten Longitudinalschwingung abgestimmt ist.

2. Vorrichtung nach Anspruch 1, gekennzeichnet durch ein polygones, ein etwa quadratisches oder rechteckiges Querschnittsprofil des Resonators (1).

3. Vorrichtung nach Anspruch 1, dadurch gekennzeichnet, dass der hohle Resonator (1) mit Flüssigkeit gefüllt oder von dieser durchflossen ist.

4. Vorrichtung nach einem der Ansprüche 1 bis 3, dadurch gekennzeichnet, dass der Resonator (1) unter Zwischenschaltung eines Transformationsstückes $\lambda/2$ (4) mit dem Schallwandler (9) verbunden ist.

5. Vorrichtung nach einem der Ansprüche 1 bis 4, dadurch gekennzeichnet, dass das Ende des Resonators (1) durch einen akustischen Transformator (3) geschlossen ist.

6. Vorrichtung nach Anspruch 1, dadurch gekennzeichnet, dass dem Resonator (1) zumindest ein Reflektor zugeordnet ist, der die Rundstrahl-Charakteristik verändert und die Abstrahlung in eine einstellbare Richtung verstärkt.

7. Vorrichtung nach wenigstens einem der Ansprüche 1 bis 6, dadurch gekennzeichnet, dass mehrere Resonatoren (1) übereinander angeordnet sind.

8. Vorrichtung nach Anspruch 7, dadurch gekennzeichnet, dass zumindest zwei Resonatoren (1) ineinander geschoben sind.

9. Verfahren zur Erzeugung uund Abstrahlung von Ultraschallenergie in Flüssigkeiten mittels eines Schallwandlers und eines angeschlossenen hohl ausgebildeten Resonators, dessen Wand mit der Flüssigkeit in Berührung steht, dadurch gekennzeichnet, dass eine Vorrichtung nach wenigstens einem der Ansprüche 1 bis 8 eingesetzt wird.

**Claims**

1. A device for the generation and radiation of ultrasonic energy in liquids comprising a sound transducer (9) and a tubular resonator (1) connected thereto, the wall of the latter being in contact with the liquid, characterized in that the end of the resonator is connected to a front surface of the sound transducer (9) at the point of a longitudional oscillation maximum, and in that the entire length of the resonator (1) is tuned to an integral multiple of half an acoustic length ($\lambda/2$) of the longitudional oscillation fed from the sound transducer (9) to the resonator (1).

2. A device according to claim 1, comprising a polygonal, for example square or rectangular cross-sectional profile of the resonator (1).

3. A device according to claim 1, characterized in that the tubular resonator (1) is filled with liquid or has liquid flowing therethrough.

4. A device according to any of the claims 1 to 3, characterized in that the resonator (1) is connected to the sound transducer (9) by way of an interposed transformation member $\lambda/2$ (4).

5. A device according to any of the claims 1 to 4, characterized in that the end of the resonator (1) is closed by an acoustic transformer (3).

6. A device according to claim 1, characterized in that at least one reflector for varying the broadcast characteristic and for amplifying the radiation in an adjustable direction is allocated to the resonator (1).

7. A device according to at least one of the claims 1 to 6, characterized in that several resonators (1) are arranged one upon the other.

8. A device according to claim 7, characterized in that at least two resonators (1) are telescoped.

9. A method for the generation and radiation of ultrasonic energy in liquids by means of a sound transducer and a tubular resonator connected thereto, the wall of which is in contact with the liquid, characterized in that a device according to at least one of the claims 1 to 8 is employed.

**Revendications**

1. Appareillage pour la production et le rayonnement d'énergie ultrasonore dans des liquides, comportant un convertisseur de son (9) et un résonateur creux (1) y connecté, dont la paroi est en contact avec le liquide, caractérisé en ce que l'extrémité du résonateur est connectée à une surface frontale du convertisseur de son (9) à l'endroit du maximum d'oscilliation longitudinale et que la longueur totale du résonateur (1) est synchronisée à un multiple entier d'une demi-longueur d'onde ($\lambda/2$) de l'oscillation longitudinale alimentée du convertisseur de son (9) dans le résonateur (1).

2. Appareillage selon la revendication 1, caractérisé en ce que le résonateur (1) présente une section transversale polygone, environ carrée ou rectangulaire.

3. Appareillage selon la revendication 1, caractérisé en ce que le résonateur creux (1) est rempli de liquide ou traversé par celui-ci.

4. Appareillage selon l'une des revendications 1 à 3, caractérisé en ce que le résonateur (1) est connecté au convertisseur de son (9) par l'intercalage d'une pièce de transformation $\lambda/2$ (4).

5. Appareillage selon l'une des revendications 1 à 4, caractérisé en ce que l'extrémité du résonateur (1) est fermée par un transformateur acoustique (3).

6. Appareillage selon la revendication 1, caractérisé en ce que pour le moins un réflecteur est attribué au résonateur (1), lequel réflecteur change la caractéristique du jet à section circulaire et renforce le rayonnement dans une direction qui peut être orientée.

7. Appareillage selon au moins l'une des revendications 1 à 6, caractérisé en ce que plusieurs résonateurs (1) sont posés l'un sur l'autre.

8. Appareillage selon la revendication 7, caractérisé en ce que pour le moins deux résonateurs (1) sont fait glissés l'un dans l'autre.

9. Procédé pour la production et le rayonnement d'énergie ultrasonore dans des liquides au moyen d'un convertisseur de son et d'un résonateur creux connecté, dont la paroi est en contact avec le liquide, caractérisé en ce qu'un appareillage selon au moins l'une des revendications 1 à 8 est installé.

Fig.1

Fig. 2

Fig.3

Fig.4